(19) Europäisches Patentamt
European Patent Office
Office européen des brevets

(11) **EP 0 811 702 A2**

# (12) EUROPÄISCHE PATENTANMELDUNG

(43) Veröffentlichungstag:
**10.12.1997 Patentblatt 1997/50**

(21) Anmeldenummer: **97108817.4**

(22) Anmeldetag: **02.06.1997**

(51) Int. Cl.$^6$: **C23C 16/44**, C23C 16/30, C30B 25/00

(84) Benannte Vertragsstaaten:
**DE FR GB IT**

(30) Priorität: **04.06.1996 DE 19622403**

(71) Anmelder:
**SIEMENS AKTIENGESELLSCHAFT
80333 München (DE)**

(72) Erfinder:
• **Rupp, Roland, Dr.
91207 Lauf (DE)**
• **Völkl, Johannes, Dr.
91056 Erlangen (DE)**

## (54) Verfahren und Vorrichtung zum Erzeugen einer Schicht durch CVD

(57) In einem CVD-Prozeß wird auf die Oberfläche (20) eines Substrats (2), die auf wenigstens 900°C gehalten wird, ein Prozeßgasstrom (5) geleitet. Aus dem Prozeßgasstrom wird auf dem Substrat eine Schicht (6) abgeschieden. Der Prozeßgasstrom wird wenigstens annähernd antiparallel zur Gravitationskraft gerichtet. Dadurch wirken sich die thermischen Auftriebskräfte nicht mehr störend auf den Prozeß aus.

FIG 1

EP 0 811 702 A2

## Beschreibung

Die Erfindung bezieht sich auf ein Verfahren und eine Vorrichtung zum Erzeugen einer Schicht auf der Oberfläche wenigstens eines Substrats.

Aus *EP-A-0 251 825* ist eine Vorrichtung zum Abscheiden von Epitaxieschichten auf Substraten durch chemische Gasphasenabscheidung (Chemical Vapour Deposition = CVD) bekannt. Diese bekannte Vorrichtung umfaßt mehrere vertikal, d.h. parallel zur Schwerkraft (Erdanziehungskraft, Gravitationskraft), angeordnete Suszeptoren, die jeweils mehrere Substrate aufnehmen und entlang ihrer Längsachse drehbar sind. Die Suszeptoren sind entlang einer Kreislinie um ein im Zentrum angeordnetes, ebenfalls vertikal verlaufendes Gaseinlaßrohr angeordnet. Durch Öffnungen in dem Gaseinlaßrohr strömen Prozeßgase zum Abscheiden der Epitaxieschichten auf den Substraten in im wesentlichen horizontaler Richtung, d.h. senkrecht zur Schwerkraft, auf die Substrate zu.

Aus *US 3,408,982* ist eine weitere Vorrichtung zum Abscheiden von Epitaxieschichten auf Substraten durch CVD bekannt. Diese bekannte Vorrichtung umfaßt einen tellerförmigen Suszeptor, der horizontal, d.h. senkrecht zur Schwerkraft, angeordnet ist und mit einem vertikal, d.h. parallel zur Schwerkraft, angeordneten rotierenden Schaft verbunden ist. Auf dem Suszeptor sind in einer Ausführungsform die Substrate horizontal angeordnet. Durch den rotierenden Schaft werden die CVD-Prozeßgase von unten nach oben geführt und treten in einen Gasraum oberhalb des Suszeptortellers ein. In dem Gasraum strömen die Prozeßgase im wesentlichen radial bezogen auf den rotierenden Schaft nach außen und treffen auf die Substrate im wesentlichen senkrecht von oben, d.h. in Richtung der Schwerkraft, auf. Unterhalb der Substrate ist eine Induktionsheizspule angeordnet, die in Form einer flachen Spirale (Pan-Cake-Spule) ausgebildet ist. In einer weiteren Ausführungsform ist der Suszeptorteller an seinen Rändern nach oben abgeschrägt und die Substrate sind auf dem schrägen Teil des Suszeptortellers nach innen geneigt angeordnet, um die Zentrifugalkraft auszugleichen. Die zugeordnete Induktionsspule ist ebenfalls schräg angeordnet. Diese aus *US-A-3,408,982* bekannte Vorrichtung ist insbesondere zum Herstellen von Siliciumepitaxieschichten vorgesehen, wobei Temperaturen zwischen 1190°C und 1450°C eingestellt werden für den CVD-Prozeß.

Der Erfindung liegt nun die Aufgabe zugrunde, ein besonderes Verfahren und eine besondere Vorrichtung zum Erzeugen einer Schicht auf der Oberfläche wenigstens eines Substrats durch chemische Dampfphasenabscheidung (CVD) aus einem Prozeßgasstrom anzugeben, bei denen die Abscheidetemperaturen am Substrat wenigstens 900° C betragen und der Prozeßgasstrom von einem kälteren Raumbereich als das wenigstens eine Substrat zur Oberfläche des wenigstens einen Substrats geleitet wird.

Diese Aufgabe wird gemäß der Erfindung gelöst mit den Merkmalen des Anspruchs 1 bzw. des Anspruchs 5.

Die Erfindung geht aus von der Beobachtung, daß bei einem im wesentlichen von oben, d.h. parallel (gleichgerichtet) zur Gravitationskraft, auf die Substratoberfläche strömenden Prozeßgasstrom wie bei einer beispielsweise aus *US-A-3,408,982* bekannten Vorrichtung eine instabile Strömungssituation entsteht. Grund dafür ist die zur Strömungsrichtung entgegengesetzte thermische Auftriebsbewegung im Prozeßgasstrom wegen des positiven Temperaturgradienten und des dadurch bewirkten Dichtegradienten im Prozeßgasstrom zum Substrat hin. Die thermischen Auftriebskräfte bewirken ungünstige Verwirbelungen im Prozeßgasstrom besonders in der Nähe der Substratoberfläche, wo mit den vergleichsweise hohen Abscheidetemperaturen von wenigstens 900° C die höchsten Temperaturen herrschen. Durch die Gasverwirbelungen wird die auf der Substratoberfläche aufgewachsene Schicht inhomogen. Die genannten strömungsdynamisch ungünstigen Verhältnisse müssen deshalb durch eine vergleichsweise schnelle Rotation der Substrate und eine Begrenzung des Gasdruckes im Prozeßgasstrom auf vergleichsweise niedrige Drücke kompensiert werden. Das Problem des thermischen Auftriebs besteht auch noch bei einer horizontalen Prozeßgasführung wie bei der aus *EP-A-0 251 825* bekannten Vorrichtung.

Der Erfindung liegt nun die Erkenntnis zugrunde, daß die Strömungsverhältnisse im Prozeßgasstrom insbesondere vor der Substratoberfläche deutlich verbessert werden, wenn der Prozeßgasstrom zumindest kurz vor dem Kontakt mit der zu behandelnden Substratoberfläche nach oben, d.h. antiparallel (entgegengesetzt gerichtet) zur Gravitationskraft, strömt. Dadurch sind die auf den Prozeßgasstrom einwirkenden thermischen Auftriebskräfte und die erzwungenen Konvektionskräfte auf den Prozeßgasstrom gleichgerichtet (parallel), und man erhält eine stabile thermische Schichtung im Prozeßgasstrom. Der Prozeßgasstrom im Bereich vor der Substratoberfläche wird somit strömungsdynamisch deutlich stabilisiert. Auch ohne Rotation des Substrats treten praktisch keine Verwirbelungen mehr im Prozeßgasstrom auf. Dies äußert sich in einer größeren Homogenität und in einer höheren Reinheit der auf der Substratoberfläche aus dem Prozeßgasstrom aufwachsenden Schicht.

Ein weiterer Vorteil der Prozeßgaszuführung von unten besteht darin, daß nun die wichtigen Prozeßparameter Rotationsgeschwindigkeit des Substrats, Druck im Prozeßgasstrom und Gasflußrate (Gasmenge pro Zeit und Volumen) des Prozeßgasstromes über einen weiten Bereich variiert und zur Verbesserung des CVD-Prozesses optimiert werden können, ohne eine Instabilität in der Prozeßgasströmung in Kauf nehmen zu müssen.

Das Verfahren zum Erzeugen einer Schicht auf einer Oberfläche wenigstens eines Substrats gemäß Anspruch 1 umfaßt folgende Verfahrensschritte:

a) an der Oberfläche des wenigstens einen Substrats werden Abscheidetemperaturen von wenigstens 900° C erzeugt,

b) ein Prozeßgasstrom wird von einem auf niedrigeren Temperaturen als den Abscheidetemperaturen liegenden Raumbereich zur Oberfläche des wenigstens einen Substrats geleitet,

c) auf der Oberfläche des wenigstens einen Substrats wird durch chemische Gasphasenabscheidung (CVD) aus dem Prozeßgasstrom die Schicht abgeschieden,

d) die Strömungsrichtung des Prozeßgasstromes wird zumindest unmittelbar vor dessen Auftreffen auf die Oberfläche des wenigstens einen Substrats wenigstens annähernd antiparallel zur Gravitationskraft (Erdanziehungskraft) eingestellt.

Die Vorrichtung zum Erzeugen einer Schicht auf einer Oberfläche wenigstens eines Substrats durch chemische Gasphasenabscheidung (CVD) aus einem Prozeßgasstrom gemäß Anspruch 5 umfaßt

a) Heizmittel zum Erzeugen von Abscheidetemperaturen von wenigstens 900° C an der Oberfläche des wenigstens einen Substrats und

b) Gasleitmittel zum Leiten des Prozeßgasstromes von einem auf niedrigeren Temperaturen als die Abscheidetemperaturen liegenden Raumbereich zur Oberfläche des wenigstens einen Substrats derart, daß der Prozeßgasstrom wenigstens unmittelbar vor dem Auftreffen auf die Oberfläche des wenigstens einen Substrats wenigstens annähernd antiparallel zur Gravitationskraft gerichtet ist.

Vorteilhafte Ausgestaltungen und Weiterbildungen des Verfahrens und der Vorrichtung ergeben sich aus den vom Anspruch 1 bzw. Anspruch 5 jeweils abhängigen Ansprüchen.

In einer Ausführungsform wird die Oberfläche des wenigstens einen Substrats wenigstens annähernd senkrecht zur Gravitationskraft angeordnet.

Vorzugsweise wird das wenigstens eine Substrat während des Abscheidens der Schicht um eine vorgegebene Drehachse gedreht. Eine solche Rotation verbessert die Homogenität der aufwachsenden Schicht, da Inhomogenitäten des Prozeßgasstromes und der Temperaturverteilung über die Substratoberfläche ausgeglichen werden.

Die Heizmittel der Vorrichtung umfassen in einer vorteilhaften Ausführungsform wenigstens einen mit dem wenigstens einen Substrat thermisch gekoppelten Suszeptor und eine Induktionsheizeinrichtung, vorzugsweise eine Induktionsspule, zum induktiven Erhitzen des wenigstens einen Suszeptors.

Die Induktionsheizeinrichtung und der wenigstens eine Suszeptor sind vorzugsweise so zueinander angeordnet, daß eine durch die Induktionsheizeinrichtung auf den wenigstens einen Suszeptor einwirkende elektromagnetische Kraft wenigstens annähernd parallel zur Gravitationskraft gerichtet ist. Dadurch wird ein stabiler mechanischer und thermischer Aufbau erreicht.

Der wenigstens eine Suszeptor ist vorzugsweise zwischen der Induktionsspule und dem wenigstens einen Substrat angeordnet. In einer besonderen Ausführungsform weist der Suszeptor dann an seiner von der Induktionsspule abgewandten Seite für jedes Substrat wenigstens eine Einstecklasche zum Einstecken und Halten des wenigstens einen Substrats auf. Die Einstecklaschen sind vorzugsweise so gegen die Horizontale geneigt angeordnet, daß jedes Substrat durch sein eigenes Gewicht in der Einstecklasche gehalten wird. Der Suszeptor kann auf einem Trägerstab abgestützt sein.

In einer weiteren vorteilhaften Ausführungsform umfaßt die Vorrichtung wenigstens eine Trägereinrichtung zum Tragen des wenigstens einen Substrats und des wenigstens einen Suszeptors. Diese Trägereinrichtung umfaßt in einer besonderen Ausgestaltung eine Trägerschale mit jeweils einer Öffnung und einer die Öffnung umgebenden Auflagefläche für jedes Substrat, wobei der Suszeptor in die Trägerschale einlegbar ist. Die Trägerschale ist vorzugsweise auf einem Trägerstab abgestützt.

Um die Wechselwirkung von Prozeßgasstrom und Trägerstab für den Suszeptor oder die Trägerschale gering zu halten, kann der Trägerstab von einem Inertgasstrom umströmt werden, beispielsweise mit Hilfe eines den Trägerstab zumindest teilweise umgebenden Rohres, oder zumindest an seiner Oberfläche aus gegenüber dem Prozeßgasstrom inertem Material bestehen.

Die Gasleitmittel umfassen in einer weiteren Ausführungsform einen Diffusor, durch den der Prozeßgasstrom strömt. Der Diffusor erzeugt einen weitgehend homogenen Gasstrom. Vorzugsweise enthalten die Gasleitmittel auch einen Gastransportbereich, durch den der Prozeßgasstrom im wesentlichen antiparallel zur Gravitationskraft vom Diffusor zur Oberfläche des wenigstens einen Substrats strömt.

Eine besonders vorteilhafte Anwendung finden das Verfahren und die Vorrichtung im Abscheiden einer Schicht aus einkristallinem Siliciumcarbid oder aus einkristallinem Galliumnitrid.

Zur weiteren Erläuterung der Erfindung wird auf die Zeichnungen Bezug genommen.

FIG 1    zeigt eine Prinzipskizze zur Veranschaulichung des CVD-Verfahrens zum Erzeugen einer Schicht auf einer Oberfläche wenigstens eines Substrats,

FIG 2    stellt eine Vorrichtung zum Abscheiden einer Schicht auf einer Substratoberfläche mit einer Widerstandsheizung dar.

FIG 3    veranschaulicht eine Trägereinrichtung für mehrere Substrate für einen Multiwafer-CVD-Prozeß in einem Querschnitt.

FIG 4    zeigt die Trägereinrichtung der FIG 3 in einer Draufsicht.

| FIG 5 | stellt eine erste Ausführungsform einer Vorrichtung zum Erzeugen von jeweils einer Schicht auf mehreren Substraten mit einer Trägereinrichtung gemäß den FIG 3 und 4 dar. |
|---|---|
| FIG 6 | zeigt eine zweite Ausführungsform einer Vorrichtung zum Erzeugen von jeweils einer Schicht auf mehreren Substraten mit einer Trägereinrichtung gemäß den FIG 3 und 4. |
| FIG 7 | veranschaulicht eine Ausführungsform einer Vorrichtung zum Beschichten eines Substrats von unten mit einer von oben rotierbaren Trägereinrichtung für das Substrat. |
| FIG 8 | stellt eine Vorrichtung zum Beschichten eines Substrats von unten mit einer von unten rotierbaren Trägereinrichtung für das Substrat dar. |
| FIG 9 | ist eine Darstellung eines Suszeptors mit Einstecklaschen für mehrere Substrate von unten. |
| FIG 10 | veranschaulicht einen Suszeptor mit Einstecklaschen für mehrere Substrate in einem Querschnitt. |

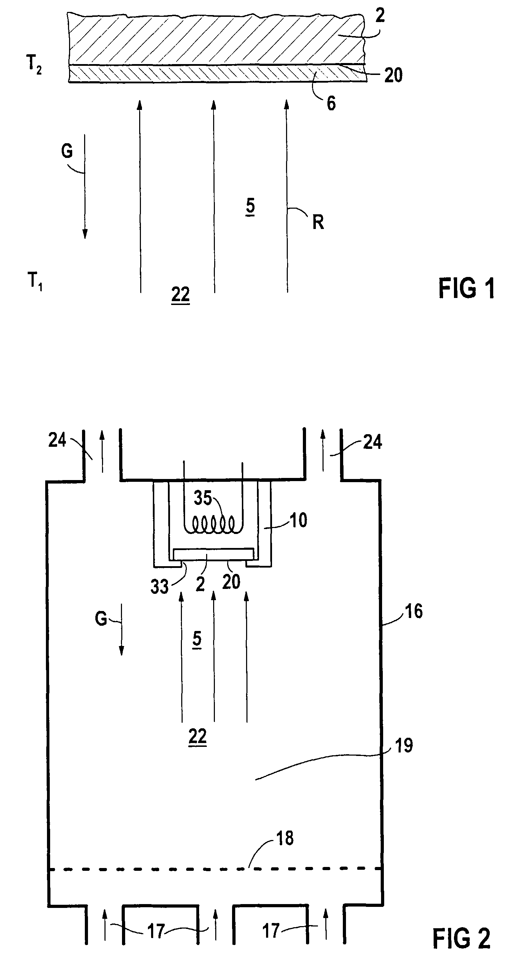

Bei dem CVD-Prozeß gemäß FIG 1 werden im Bereich einer Oberfläche 20 eines Substrats 2 Abscheidetemperaturen $T_2$ von wenigstens 900° C erzeugt. Ein unterhalb des Substrats 2, d.h. entgegengesetzt zur durch einen mit **G** bezeichneten Pfeil dargestellten Gravitationskraft, angeordneter Raumbereich ist mit 22 bezeichnet und befindet sich auf Temperaturen $T_1$, die unter den Abscheidetemperaturen $T_2$ liegen. Aus diesem Raumbereich 22 strömt auf die Oberfläche 20 des Substrats 2 ein Prozeßgasstrom 5, dessen Strömungsrichtung mit einem mit R bezeichneten Pfeil dargestellt ist. Da der Raumbereich 22 kälter ist als das Substrat 2, erfährt der Prozeßgasstrom 5 entlang seiner Strömungsrichtung R einen positiven Temperaturgradienten. Dadurch wirken auf den Prozeßgasstrom 5 thermische Auftriebskräfte, die zur Oberfläche 20 des Substrats 2 hin zunehmen. Aus dem Prozeßgasstrom 5 scheidet sich auf der Oberfläche 20 des Substrats 2 durch chemische Reaktionen aus der Gasphase eine Schicht 6 ab.

Die Strömungsrichtung R und die Gravitationskraft **G** zeigen in die entgegengesetzte Richtung, sind also antiparallel zueinander. Dadurch sind die Konvektionskraft und die thermischen Auftriebskräfte auf den Prozeßgasstrom 5 gleichgerichtet (parallel) im Unterschied zu bekannten CVD-Prozessen, bei denen die Prozeßgase von oben auf das Substrat geleitet werden. Die bei den bekannten CVD-Prozessen auftretenden Verwirbelungen im Prozeßgasstrom 5 insbesondere nahe der Oberfläche 20 des Substrats 2 werden durch diese besondere Maßnahme unterdrückt.

Die Oberfläche 20 des Substrats 2 ist in der dargestellten Ausführungsform senkrecht zur Gravitationskraft **G** und damit zur Strömungsrichtung R des Prozeßgasstromes 5 gerichtet, kann aber auch gegen diese Strömungsrichtung R geneigt sein und sogar parallel zur Strömungsrichtung R verlaufen.

In FIG 2 ist eine Vorrichtung zum Beschichten einer Substratoberfläche durch CVD gezeigt, bei der ein Substrat 2 von einer Trägereinrichtung (Substrathalter) 10 gehalten wird. Das Substrat 2 ist auf dem Rand einer Öffnung 33 in der Trägereinrichtung 10 abgestützt. Die Trägereinrichtung 10 ist oben an der oberen Wand des Reaktors 16 vorzugsweise drehbar befestigt. Die Öffnung 33 der Trägereinrichtung 10 gibt eine Oberfläche 20 des Substrats 2 frei, auf die von unten von Gasleitmitteln ein Prozeßgasstrom 5 geleitet wird. Die Gasleitmittel umfassen einen von den Seitenwänden eines Reaktors 16 begrenzten Gastransportbereich 19 und einen unten an den Gastransportbereich 19 angrenzenden Diffusor 18. Durch Einlaßöffnungen 17 des Reaktors 16 strömen für den CVD-Prozeß vorgesehene Prozeßgase, und der aus diesen Prozeßgasen zusammengesetzte Prozeßgasstrom 5 strömt durch den Diffusor 18 in den Gastransportbereich 19 zum Substrat 2 hin. Die überschüssigen Prozeßgase treten über Auslaßöffnungen 24 wieder aus dem Reaktor 16 aus und werden vorzugsweise durch Pumpen abgesaugt. Auf der von der Oberfläche 20 abgewandten Seite des Substrats 2 ist eine Widerstandsheizung 35 angeordnet zum Beheizen des Substrats 2 auf die gewünschten Abscheidetemperaturen.

Die Strömungsrichtung R des Prozeßgasstromes 5 ist somit wieder antiparallel zur Gravitationskraft **G** gerichtet, weshalb der durch den Temperaturanstieg vom unteren Raumbereich 21 des Gastransportbereichs 19 zum Substrat 2 hin bewirkte Auftrieb im Prozeßgasstrom 5 die Strömung nicht destabilisiert.

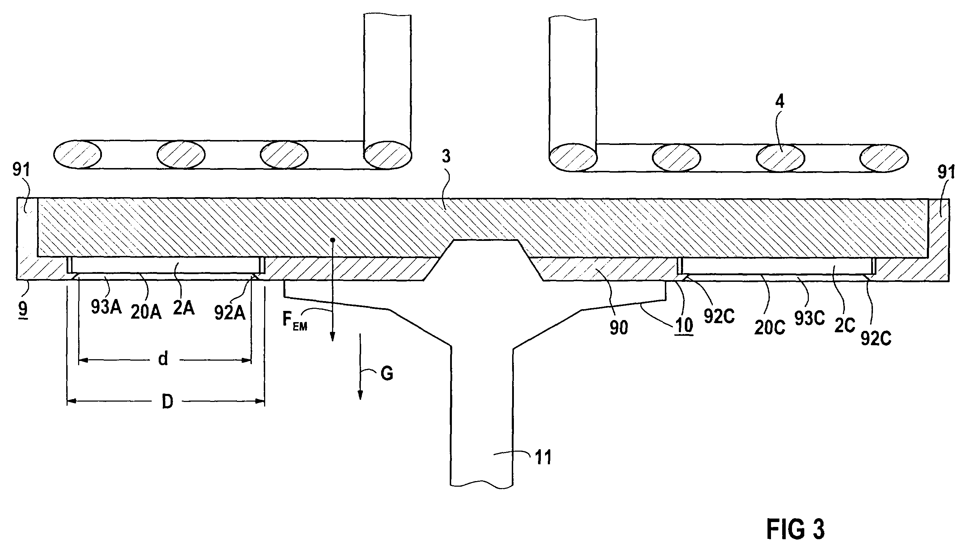

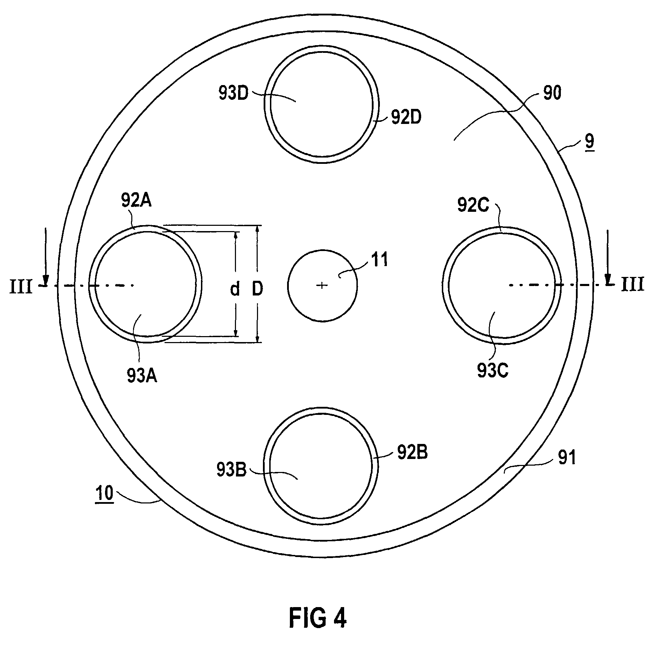

Eine Trägereinrichtung 10 für mehrere Substrate für eine CVD-Vorrichtung zum Abscheiden von Schichten auf den Substraten ist in FIG 3 in einem Querschnitt und in FIG 4 in einer Draufsicht dargestellt. In FIG 3 sind zusätzlich Heizmittel mit einem Suszeptor 3 und einer Induktionsspule 4 dargestellt. In FIG 4 ist die Trägereinrichtung 10 in einer Draufsicht von oben ohne Suszeptor 3 und Induktionsspule 4 dargestellt. Im Querschnitt der FIG 4 sind zwei Substrate 2A und 2C dargestellt, in der Draufsicht der FIG 2 vier Substrate 2A, 2B, 2C und 2D. Die Trägereinrichtung 10 umfaßt eine Trägerschale 9 und einen Trägerstab 11, der zentrisch die Trägerschale 9 abstützt. Die Trägerschale 9 besteht aus einer Grundplatte 90 und einem seitlichen, nach oben ragenden Rand 91. In der Grundplatte 90 sind für jedes Substrat 2A bis 2D jeweils eine Öffnung 93A bis 93D vorgesehen. Um jede dieser Öffnungen 93A bis 93D ist eine Auflagefläche 92A bis 92D in der Grundplatte 90 gebildet, auf die jeweils eines der Substrate 2A bis 2D aufgelegt wird. Vorzugsweise sind die Auflageflächen 92A bis 92D in die Grundplatte zurückgesetzt, so daß ein zylindrisches Lager für das Substrat gebildet ist mit einem durch die Öffnung 93A bis 93D definierten inneren Durchmesser d und einem durch die radiale Ausdehnung der Auflagefläche 92A bis 92D definierten äußeren Durchmesser D. Der innere Durchmesser D ist kleiner gewählt als der Durchmesser der Substrate 2A bis 2D, während der äußere Durchmesser D größer gewählt ist als der Durchmesser der Substrate 2A bis 2D. Neben der dargestellten Kreisform können die Auflageflächen 92A bis 92D natürlich auch einer anderen Form der Substrate angepaßt werden, beispielsweise einer rechteckigen Form. Im allgemeinen sind auch mehr als vier Auflageflächen für entsprechend mehr Substrate vorgesehen, die vorzugsweise dicht nebeneinander angeordnet werden.

Nach dem Einbringen der Substrate 2A bis 2D auf die entsprechenden Auflageflächen 92A bis 92D wird in die Trägerschale 9 der Suszeptor 3 eingebracht, der vorzugsweise dem Innendurchmesser der Trägerschale 9 angepaßt ist und insbesondere die Form einer Kreisscheibe haben kann. Der Suszeptor 3 ist thermisch mit den Substraten 2A bis 2D gekoppelt und steht dazu vorzugsweise in direktem Kontakt mit den Substraten 2A bis 2D. Die Trägerschale 9 ist vorzugsweise auf den Trägerstab 11 aufsteckbar und damit lösbar verbunden. Dies ermöglicht einen einfachen Wechsel der Substrate nach einem CVD-Prozeß. Die Induktionsspule 4 ist vorzugsweise eine Flachspule in der Art einer Pan-Cake-Spule und ist oberhalb des Suszeptors 3 wenigstens annähernd parallel zu der Trägerschale 9 und zu den Substraten 2A bis 2D sowie dem Suszeptor 3 angeordnet.

Der Suszeptor 3 besteht im allgemeinen aus einem elektrisch leitfähigen Material. Bei Anlegen einer vorzugsweise hochfrequenten Wechselspannung an die Induktionsspule 4 werden in dem Suszeptor 3 Wirbelströme induziert, die in Joulesche Wärme umgewandelt werden. Durch die thermische Kopplung wird diese Wärme vom Suszeptor 3 auf die Substrate 2A bis 2D übertragen. Aufgrund der Induktion (Lenzsche Regel) wirkt auf den Suszeptor 3 eine elektromagnetische Kraft (Kraftvektor) $F_{EM}$.

Die besondere Anordnung von Suszeptor 3 und Induktionsspule 4 relativ zueinander hat zur Folge, daß diese elektromagnetische Kraft $F_{EM}$ gleichgerichtet zur Gewichtskraft des Suszeptors 3 und damit zur Gravitationskraft (Kraftvektor) $G$ ist. Gleichgerichtet bedeutet, daß die zugehörigen Kraftpfeile (Vektoren) in die gleiche Richtung zeigen. Die Gesamtkraft auf den Suszeptor 3 ergibt sich als vektorielle Summe $F_{EM} + G$ der elektromagnetischen Kraft $F_{EM}$ und der Gravitationskraft $G$. Diese Gesamtkraft $F_{EM} + G$ zeigt immer in Richtung der Gravitationskraft $G$ unabhängig von dem Stromfluß in der Induktionsspule 4 und ist betragsmäßig immer wenigstens so groß wie der Betrag der auf den Suszeptor 3 wirkenden Schwerkraft $G$. Damit wird während des Abscheidens der Schichten und des Betriebs der Induktionsspule 4 der Suszeptor 3 immer in seiner Lage gehalten und hebt nicht von den Substraten 2A bis 2D ab. Somit sind auch eine gleichmäßige Wärmeversorgung der Substrate 2A bis 2D und gleichmäßige Temperaturen an deren Substratoberflächen 20A bis 20D gewährleistet. Da überdies die Substrate 2A bis 2D durch ihre eigene Gewichtskraft und die Gewichtskraft des Suszeptors 3 gegen die zugehörigen Auflageflächen 92A bis 92D gedrückt werden, können praktisch keine Verunreinigungen vom Suszeptor 3 zu den behandelten Substratoberflächen 20A bis 20D gelangen. Dadurch wird beim Aufwachsen einer Epitaxieschicht auf jedem Substrat 2A bis 2D die Qualität der aufwachsenden Epitaxieschicht verbessert.

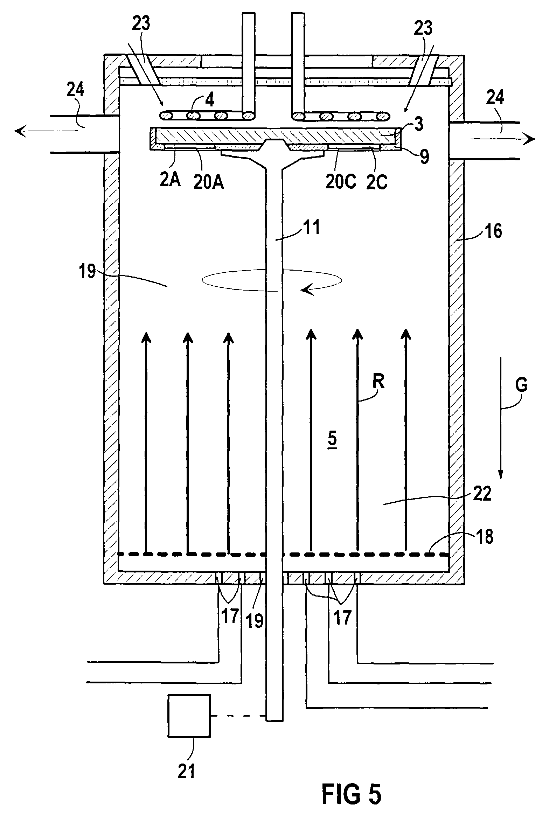

FIG 5 zeigt eine Vorrichtung zum Abscheiden von Schichten auf mehreren Substraten durch CVD. Die Vorrichtung enthält eine Trägereinrichtung mit einer Trägerschale 9 und einem Trägerstab 11 sowie einen Suszeptor 3, die analog wie in FIG 3 aufgebaut sind und denen wie in FIG 3 eine Induktionsspule 4 zugeordnet ist. Dieser Aufbau ist nun in einem Reaktor 16 angeordnet, an dessen Unterseite, d.h. in Richtung der Schwerkraft $G$ gesehen, unterhalb der Substrate 2A und 2C Mittel zum Richten eines Prozeßgasstromes 5 auf die Substratoberflächen 20A und 20C vorgesehen sind. Diese Mittel zum Richten des Prozeßgasstromes 5 umfassen Gaseinlaßöffnungen 17 in dem Reaktor 16, durch die die verschiedenen Prozeßgase in den Reaktor 16 geleitet werden und einen Diffusor 18, mit dessen Hilfe ein homogener Prozeßgasstrom 5 erzeugt wird. Der Diffusor 18 kann mit einem Drahtgeflecht einer vorgesehenen Maschenweite gebildet sein. Der Prozeßgasstrom 5 strömt auf die Substratoberflächen 20A bis 20E und wird danach seitlich abgelenkt und über mit Pumpen verbundenen Auslässe 24 aus dem Reaktor 16 geführt. Vorzugsweise sind zum Schutz der Induktionsspule 4 vor dem Prozeßgasstrom 5 Gaseinlässe 23 vorgesehen, über die die Induktionsspule 4 und vorzugsweise auch der Suszeptor 3 mit einem Inertgas, vorzugsweise Argon, gespült werden.

Der Trägerstab 11, auf den die Trägerschale 9 aufgesetzt ist, geht durch den gesamten Reaktor 16 nach unten und wird durch eine gasdichte Öffnung 19, insbesondere eine Drehdichtung, außerhalb des Reaktors 16 geführt. Dort sind Rotationsmittel 21 vorgesehen, die mit dem Trägerstab 11 in Wirkverbindung stehen und den Trägerstab 11 entlang seiner Längsachse rotieren können. Die Rotationsgeschwindigkeit wird dabei entsprechend den Anforderungen variabel eingestellt. Als Rotationsmittel 21 kann beispielsweise ein Elektromotor mit einer entsprechenden Übersetzung vorgesehen sein. Vorzugsweise kann der Trägerstab 11 auch über die gasdichte Öffnung 19 entlang seiner Längsachse verschoben werden, um den Ein- und Ausbau der Substrate in dem Reaktor 16 zu erleichtern.

Die wieder entgegengesetzt zur Schwerkraft $G$ gerichtete Strömungsrichtung R des Prozeßgasstromes 5 zeigt in Richtung der dargestellten Pfeile. Durch die antiparallele Ausrichtung von Strömungsrichtung R und Gravitationskraft $G$ wird eine stabile thermische Schichtung im Gasraum innerhalb des Reaktors 16 erreicht, die praktisch keine Verwirbelung zeigt. Alle Parameter wie Rotationsgeschwindigkeit, Druck und Gasfluß (Strömungsrate) können nun frei zur Verbesserung des Wachstumsprozesse optimiert werden.

Da der Trägerstab 11 in dieser Ausführungsform gemäß FIG 5 mit dem Prozeßgasstrom 5 in Berührung tritt, kann der Trägerstab 11 zumindest an seiner Oberfläche aus einem gegenüber dem Prozeßgasstrom 5 chemisch nicht reaktiven (inerten) Material bestehen.

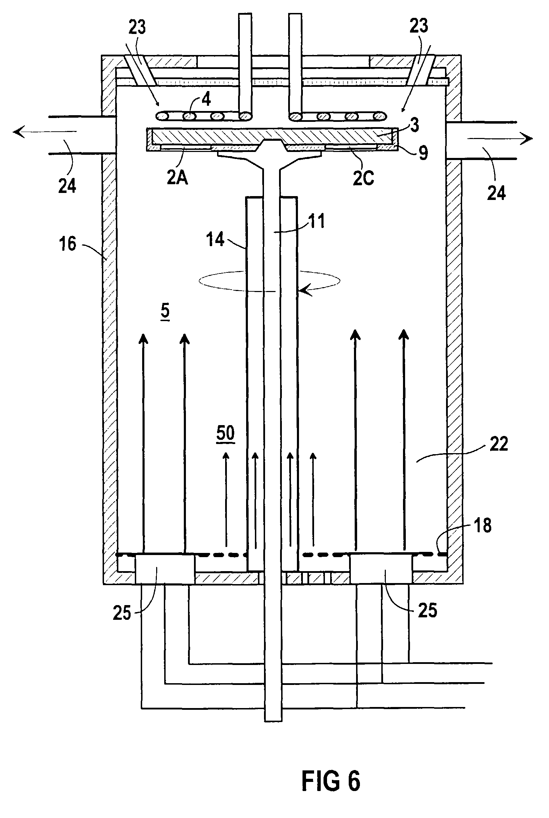

Der Trägerstab 11 kann aber auch wie in der weiteren Ausführungsform gemäß FIG 6 von einem Inertgas umspült werden. Dazu kann der Trägerstab insbesondere von einem Rohr 14 umgeben sein, das aus einem gegenüber dem Prozeßgasstrom 5 inerten Material bestehen kann. In der in FIG 6 dargestellten vorteilhaften Ausführungsform strömt der Prozeßgasstrom 5 aus einem vorzugsweise konzentrisch um den Trägerstab 11 angeordneten Düsenring 25 nach oben. Der Düsenring 25 kann mit einem Diffusor 18 umgeben sein, der nur von der Auslaßöffnung der Düse 25 unterbrochen ist. Durch den innerhalb des Düsenrings 25 liegenden Teil des Diffusors 18 wird der Inertgasstrom 50 geleitet aus einem Inertgas, beispielsweise einem Edelgas wie Argon (Ar). Der Inertgasstrom 50 strömt im wesentlichen parallel zum Prozeßgasstrom 5. Wenigstens ein Teil dieses Inertgasstromes 50 spült den Zwischenraum zwischen dem Rohr 14 und dem Trägerstab 11. Ein weiterer Teil des Inertgasstromes 50 kann außen am Rohr 14 entlangströmen. Der Inertgasstrom 50 wird von dem Prozeßgasstrom 5 wie von einem beispielsweise zylindrischen Mantel umgeben.

Ein Inertgasstrom 50 wie in FIG 6 kann auch direkt um den Trägerstab 11 ohne Rohr 14 erzeugt werden, um Reaktionen zwischen dem Trägerstab 11 und dem Prozeßgasstrom 5 zu verhindern.

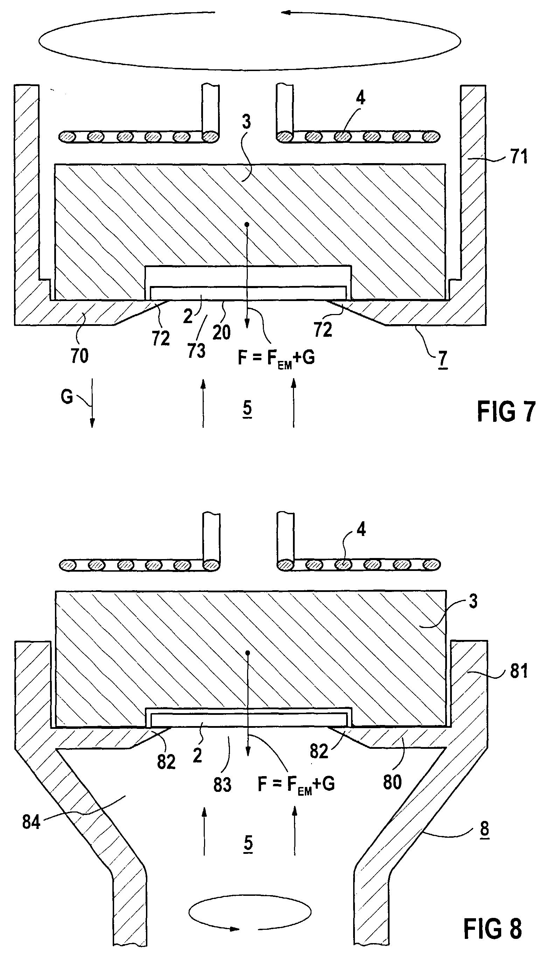

In FIG 7 ist eine weitere Ausführungsform einer Vorrichtung zum Beschichten eines Substrats 2 durch CVD gezeigt. Das Substrat 2 liegt mit seinem Rand auf einer Auflagefläche 72 einer Trägereinrichtung 7. Die Auflagefläche 72 bildet den Rand einer Öffnung 73 in einer Grundplatte 70 der Trägereinrichtung 7. Durch die Öffnung 73 in der Grundplatte 70 ist die nach unten gewandte Oberfläche 20 des Substrats 2 zugänglich. Aus einem mit 5 bezeichneten Prozeßgasstrom, der von unten auf die Oberfläche 20 des Substrats 2 strömt, kann deshalb das Substrat 2 an seiner Oberfläche 20 durch ein CVD-Verfahren mit einer nicht dargestellten Schicht versehen werden. Aus strömungsdynamischen Gründen ist die Auflagefläche 72 vorzugsweise schräg gestaltet, so daß ihr Durchmesser zum Substrat 2 hin kontinuierlich abnimmt. Die Auflagefläche 72 und das aufliegende Substrat 2 sind im wesentlichen senkrecht zur Schwerkraft **G** gerichtet. Neben der Grundplatte 70 weist die Trägereinrichtung 7 ein Seitenteil 71 auf, das beispielsweise hohlzylindrisch ausgestaltet sein kann und sich nach oben, also entgegengesetzt zur Schwerkraft **G**, fortsetzt. Vorzugsweise ist die Trägereinrichtung 7 von oben her rotierbar um eine vorzugsweise parallel zur Schwerkraft **G** verlaufende Drehachse. In der Trägereinrichtung 7 ist auf der Grundplatte 70 ein Suszeptor 3 angeordnet, der von dem Seitenteil 71 begrenzt ist und thermisch mit dem Substrat 2 gekoppelt ist. Oberhalb des Suszeptors 3 ist wieder eine Induktionsspule 4 angeordnet. Die auf den Suszeptor 3 resultierende

Gesamtkraft

$$F = F_{EM} + G$$

ist mit einem Pfeil dargestellt, der die Richtung dieser wirkenden Kraft darstellt, und ist immer gleichgerichtet zur Gravitationskraft **G**, so daß der Suszeptor 3 fest auf der Trägereinrichtung 7 verharrt und eine konstante thermische Kopplung zum Substrat 2 sowie ein stabiler mechanischer Aufbau gewährleistet sind. Insbesondere kann der Suszeptor 3 auch bei sich ändernder elektrischer Energie in der Induktionsspule 4 nicht von der Unterlage 15 abheben.

FIG 8 zeigt einen ähnlichen Aufbau der Vorrichtung wie in FIG 7, jedoch mit einer abgewandelten Trägereinrichtung, die mit 8 bezeichnet ist. Die Trägereinrichtung 8 weist ebenso wie die Trägereinrichtung 7 in FIG 3 eine Grundplatte 80 auf mit einer Öffnung 83 und einer Auflagefläche 82, auf der das Substrat 2 aufliegt. Jedoch setzt sich die Trägereinrichtung 8 nicht wie in FIG 3 nach oben, sondern nach unten in Richtung der Schwerkraft **G** fort und ist auch, bezogen auf das Substrat 2, unten befestigt. Ferner ist die Trägereinrichtung 8 innen hohl und wird in dem von ihr umschlossenen Hohlraum 84 von den Prozeßgasen 5 durchströmt. Zum Abführen der Prozeßgase 5 nach ihrem Auftreffen auf das Substrat 2 sind vorzugsweise nicht dargestellte Öffnungen im oberen Bereich der Trägereinrichtung 8 vorgesehen. Vorzugsweise verjüngt sich der Hohlraum 84 innerhalb der Trägereinrichtung 8 nach unten und nimmt dort die Gestalt eines Schaftes an. Vorzugsweise ist dieser schaftförmige Teil der Trägereinrichtung 8 mit Rotationsmitteln, beispielsweise einem Motor, verbunden zum Rotieren des Substrats 2 während der Behandlung vorzugsweise um eine parallel zur Gravitationskraft **G** gerichtete Drehachse. Die Drehraten für diese Rotation des wenigstens einen Substrats 2 werden im allgemeinen zwischen etwa 5 Upm (Umdrehungen pro Minute) und etwa 1500 Upm und vorzugsweise zwischen etwa 10 Upm und etwa 800 Upm eingestellt.

Auf der Grundplatte 80 der Trägereinrichtung 8 ist wieder, umfaßt von einem Seitenteil 81, ein Suszeptor 3 angeordnet, der von einer über dem Suszeptor 3 angeordneten Induktionsspule 4 induktiv erwärmt wird zum Beheizen des Substrats 2. Der Suszeptor 3 wird möglichst paßgenau auf das Substrat 2 aufgesetzt.

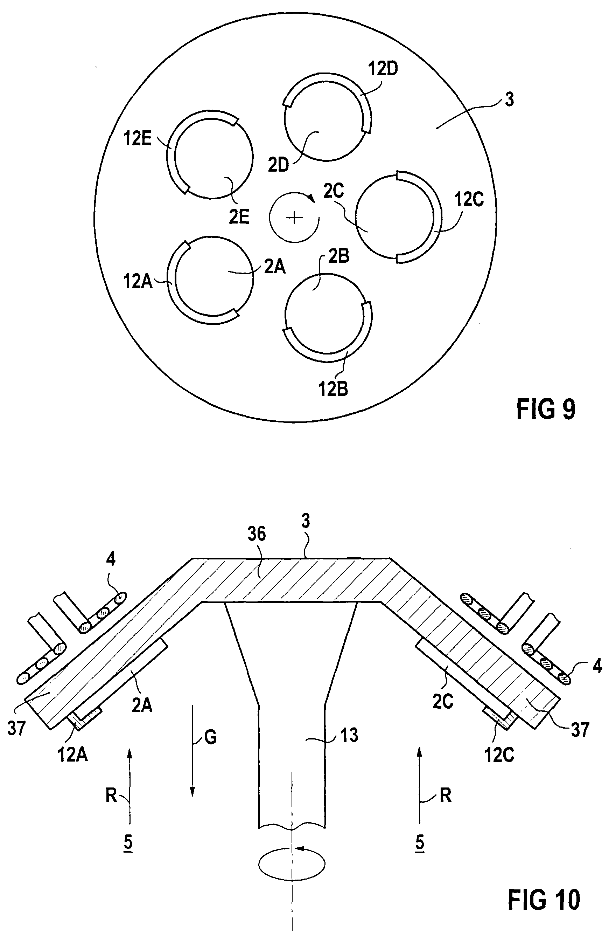

In FIG 9 ist ein Suszeptor 3 von unten dargestellt, der selbst als Trägereinrichtung für das wenigstens eine Substrat vorgesehen ist. Der Suszeptor 3 weist an seiner Unterseite für jedes Substrat 2A bis 2E eine Einstecklasche (Aufnahmetasche) 12A bis 12E auf, die in ihrer Form der Form des zugeordneten Substrats 2A bis 2E angepaßt ist und im Beispiel der Figur halbkreisförmig ist. Die Substrate 2A bis 2E können in die zugehörigen Einstecklaschen 12A bis 12E seitlich eingesteckt werden und werden von diesen Einstecklaschen 12A bis 12E festgehalten. Vorzugsweise wird der Suszeptor 3 um eine Drehachse zentrisch gedreht. Die Einteckla-

schen 12A bis 12E sind nun radial so angeordnet, daß die Substrate 2A bis 2E in die zugehörige Einstecklasche 12A bis 12E durch die Zentrifugalkraft bei der Drehung des Suszeptors 3 gedrückt werden und somit zusätzlich mechanisch stabilisiert werden. Die Beschichtung der Substrate 2A bis 2E geschieht in dieser Ausführungsform von unten, d.h. in Blickrichtung auf die Unterseite des Suszeptors 3. Die nicht dargestellte Induktionsspule ist auf der Oberseite des Suszeptors 3 angeordnet.

FIG 10 schließlich zeigt einen ebenfalls als Substrathalter vorgesehenen Suszeptor 3 mit mehreren Einstecklaschen, von denen im dargestellten Querschnitt nur zwei Einstecklaschen 12A und 12C zu sehen sind. In die Einstecklaschen 12A und 12C werden jeweils ein Substrat 2A bzw. 2C eingesteckt. Die Einstecklaschen 12A und 12C sind an der Unterseite eines zusammenhängenden Seitenteils 37 oder jeweils eines von mehreren Seitenteilen 37 des Suszeptors 3 befestigt. Das wenigstens eine Seitenteil 37 ist mit einem Zentralteil 36 des Suszeptors 3 verbunden, das auf einem Trägerstab 13 angeordnet ist. Der Trägerstab 13 mit dem darauf abgestützten Suszeptor 3 ist vorzugsweise wieder drehbar um eine Längsachse des Trägerstabes 13. Das wenigstens eine Seitenteil 37 ist nun gegen die Gravitationskraft G um einen spitzen Winkel nach oben geneigt, so daß eine Komponente der Gravitationskraft G die Substrate 2A und 2C fest in die Einstecklaschen 12A und 12C drückt. Außerdem wird durch die schräg gegen den Trägerstab 13 nach innen geneigte Lage der Substrate 2A und 2C auch die Zentrifugalkraft bei der Rotation günstig aufgefangen, so daß die Substrate 2A und 2C sicher in ihrer Position verharren. Dem wenigstens einen Seitenteil 37 ist an seiner von den Substraten 2A und 2C abgewandten Oberseite eine vorzugsweise entsprechend schräg angeordnete Induktionsspule 4 zugeordnet. Der Prozeßgasstrom 5 wird wieder von unten auf die Substrate 2A und 2C gerichtet.

Das Verfahren und die Vorrichtung gemäß der Erfindung werden vorzugsweise zum Aufwachsen von einkristallinen Siliciumcarbidschichten oder einkristallinen Galliumnitridschichten durch einen CVD-Prozeß. CVD-Prozesse zum Herstellen von einkristallinen SiC-Schichten oder von einkristallinen Galliumnitridschichten sind in einer Vielzahl von Ausführungsformen bekannt.

Als Prozeßgase für den Prozeßgasstrom 5 werden in einem SiC-CVD-Prozeß Arbeitsgase zum Zuführen von Silicium (Si) und Kohlenstoff (C) und vorzugsweise wenigstens ein Trägergas, das im allgemeinen Wasserstoff ist, und gegebenenfalls auch ein Dotiergas zum Dotieren des aufwachsenden Siliciumcarbids verwendet. Beim Auftreffen des Gasgemisches des Prozeßgasstromes 5 auf das beheizte Substrat scheidet sich durch chemische Reaktion aus den Arbeitsgasen (Quellgasen) unter Mitwirkung des Trägergases Siliciumcarbid ab. Die Temperaturen am Substrat werden über die Energie der Induktionsspule 4 eingestellt. Zum Aufwachsen von Siliciumcarbid durch CVD werden im allgemeinen Abscheidetemperaturen zwischen etwa 900°C und etwa 2500°C eingestellt.

Zum Herstellen von einkristallinen GaN-Schichten können als Arbeitsgase insbesondere Ammoniak und Galliumkohlenwasserstoffverbindungen wie beispielsweise Trimethyl- oder Triethylgallium verwendet werden. Die Substrate können insbesondere aus $Al_2O_3$ oder SiC bestehen. Die Abscheidetemperaturen am Substrat werden vorzugsweise zwischen etwa 950° C und etwa 1100° C eingestellt.

Vorzugsweise sind die Trägerschale 9 und der Trägerstab 11 aus einem gegenüber dem Prozeßgasstrom 5 inerten Material oder zumindest mit einem inerten Material beschichtet, beispielsweise mit Tantalcarbid oder mit Siliciumcarbid in einem SiC-CVD-Prozeß. Auch das Rohr 14 gemäß FIG 6 kann wenigstens teilweise aus SiC oder Tantalcarbid sein.

Ein Vorteil der Anordnung der Heizung oberhalb der Substrate und der Rotation des Trägerstabes von unten ist bei den entsprechenden Ausführungsformen, daß die elektrischen Zuleitungen für die Heizung und die Drehdurchführungen für die Rotation entkoppelt, d.h. auf verschiedenen Seiten des Reaktors angeordnet, sind und daher einfacher ausgeführt werden können.

**Patentansprüche**

1. Verfahren zum Erzeugen einer Schicht (6) auf einer Oberfläche (20) wenigstens eines Substrats (2), bei dem

   a) an der Oberfläche (20) des Substrats (2) Abscheidetemperaturen ($T_2$) von wenigstens 900° C eingestellt werden,
   b) ein Prozeßgasstrom (5) von einem auf niedrigeren Temperaturen ($T_1$) als den Abscheidetemperaturen ($T_2$) liegenden Raumbereich (22) zur Oberfläche (20) des Substrats (2) geleitet wird,
   c) auf der Oberfläche (20) des Substrats durch chemische Gasphasenabscheidung (CVD) aus dem Prozeßgasstrom (5) die Schicht (6) abgeschieden wird,
   d) der Prozeßgasstrom (5) zumindest unmittelbar vor dem Auftreffen auf die Oberfläche (20) des Substrats (2) wenigstens annähernd antiparallel zur Gravitationskraft (G) gerichtet wird.

2. Verfahren nach Anspruch 1, bei dem die Oberfläche (20) des wenigstens einen Substrats (2) wenigstens annähernd senkrecht zur Gravitationskraft (G) ausgerichtet wird.

3. Verfahren nach Anspruch 1 oder Anspruch 2, bei dem das wenigstens eine Substrat (2) um eine vorgegebene Drehachse rotiert wird.

**4.** Verfahren nach einem der vorhergehenden Ansprüche zum Abscheiden einer Schicht (6) aus einkristallinem Siliciumcarbid oder aus einkristallinem Galliumnitrid.

**5.** Vorrichtung zum Erzeugen einer Schicht (6) auf einer Oberfläche (20) wenigstens eines Substrats (2) durch chemische Gasphasenabscheidung (CVD) aus einem Prozeßgasstrom (5) mit

   a) Heizmitteln (3,4) zum Erzeugen von Abscheidetemperaturen ($T_2$) von wenigstens 900° C an der Oberfläche (20) des Substrats (2) und
   b) Gasleitmitteln (16,18) zum Leiten des Prozeßgasstromes (5) von einem auf niedrigeren Temperaturen ($T_1$) als die Abscheidetemperaturen ($T_2$) liegenden Raumbereich (22) zur Oberfläche (20) des Substrats (2) derart, daß der Prozeßgasstrom (5) wenigstens unmittelbar vor dem Auftreffen auf die Oberfläche (20) des Substrats (2) wenigstens annähernd antiparallel zur Gravitationskraft (**G**) gerichtet ist.

**6.** Vorrichtung nach Anspruch 5, bei der die Heizmittel

   a) wenigstens einen mit dem wenigstens einen Substrat thermisch gekoppelten Suszeptor (3) und
   b) eine Induktionsheizeinrichtung (4) zum induktiven Erhitzen des wenigstens einen Suszeptors (3) umfassen.

**7.** Vorrichtung nach Anspruch 6, bei der die Induktionsheizeinrichtung (4) und der wenigstens eine Suszeptor (3) so zueinander angeordnet sind, daß eine durch die Induktionsheizeinrichtung (4) auf den wenigstens einen Suszeptor (3) einwirkende elektromagnetische Kraft ($F_{EM}$) wenigstens annähernd parallel zur Gravitationskraft (**G**) gerichtet ist.

**8.** Vorrichtung nach Anspruch 6 oder Anspruch 7, bei der die Induktionsheizeinrichtung wenigstens eine Induktionsspule (4) umfaßt.

**9.** Vorrichtung nach Anspruch 8, bei der der wenigstens eine Suszeptor (3) zwischen der Induktionsspule (4) und dem wenigstens einen Substrat (2) angeordnet ist.

**10.** Vorrichtung nach Anspruch 9, bei der der Suszeptor (3) an seiner von der Induktionsspule (4) abgewandten Seite für jedes Substrat (2A bis 2F) wenigstens eine Einstecklasche (12A bis 12E) zum Befestigen des wenigstens einen Substrats (2A bis 2F) aufweist.

**11.** Vorrichtung nach Anspruch 10, bei der der Suszeptor (3) so ausgebildet ist, daß jedes Substrat (2A bis 2F) durch sein eigenes Gewicht in der Einstecklasche (12A bis 12E) gehalten wird.

**12.** Vorrichtung nach einem der Ansprüche 9 bis 11, bei der der Suszeptor (3) auf einem Trägerstab (13) abgestützt ist.

**13.** Vorrichtung nach einem der Ansprüche 5 bis 9 mit wenigstens einer Trägereinrichtung (7,8,9) zum Tragen des wenigstens einen Substrats (2) und des wenigstens einen Suszeptors (3).

**14.** Vorrichtung nach Anspruch 13, bei der die Trägereinrichtung eine Trägerschale (9) mit jeweils einer Öffnung und einer die Öffnung umgebenden Auflagefläche (92A bis 92F) für jedes Substrat (2A bis 2F) umfaßt, wobei der Suszeptor (3) in die Trägerschale einlegbar ist.

**15.** Vorrichtung nach Anspruch 14 mit einem Trägerstab (11), auf dem die Trägerschale (9) abgestützt ist.

**16.** Vorrichtung nach Anspruch 12 oder Anspruch 15, bei der der Trägerstab (11,13) zumindest an seiner Oberfläche aus gegenüber dem Prozeßgasstrom (5) inertem Material besteht.

**17.** Vorrichtung nach Anspruch 12 oder Anspruch 15 mit Mitteln zum Umspülen des Trägerstabes (11,13) wenigstens teilweise mit einem Inertgasstrom (50).

**18.** Vorrichtung nach einem der Ansprüche 5 bis 17 mit Rotationsmittel (21) zum Rotieren des wenigstens einen Substrats (2,2A bis 2F) um eine vorgegebene Drehachse.

**19.** Vorrichtung nach einem der Ansprüche 5 bis 18, bei der die Oberfläche (20) des wenigstens einen Substrats (2) wenigstens annähernd senkrecht zur Gravitationskraft (**G**) angeordnet ist.

**20.** Vorrichtung nach einem der Ansprüche 5 bis 19, bei der die Gasleitmittel einen Diffusor (18), durch den der Prozeßgasstrom (5) strömt, umfassen.

**21.** Vorrichtung nach Anspruch 20, bei der die Gasleitmittel einen Gastransportbereich (19) umfassen, durch den der Prozeßgasstrom (5) im wesentlichen antiparallel zur Gravitationskraft (**G**) vom Diffusor (18) zur Oberfläche (20) des wenigstens einen Substrats (2) strömt.

**22.** Vorrichtung nach einem der Ansprüche 5 bis 21 zum Abscheiden einer Schicht (6) aus einkristallinem Siliciumcarbid oder aus einkristallinem Galliumnitrid.

FIG 1

$T_2$

$T_1$

G

2

20

6

5

R

22

FIG 2

24

24

35

10

33  2  20

G

16

5

19

22

18

17  17

FIG 3

EP 0 811 702 A2

FIG 4

11

FIG 5

FIG 6

$$F = F_{EM} + G$$

**FIG 7**

$$F = F_{EM} + G$$

**FIG 8**

FIG 9

FIG 10